Europäisches Patentamt

European Patent Office

Office européen des brevets

(19)

(11) Publication number: **0 202 515 B1**

# EUROPEAN PATENT SPECIFICATION

(12)

(45) Date of publication of patent specification: **13.03.91**

(21) Application number: **86105956.6**

(22) Date of filing: **02.11.83**

(51) Int. Cl.5: **H01L 27/10**

(60) Publication number of the earlier application in accordance with Art.76 EPC: **0 108 390**

(54) Semiconductor memory.

(30) Priority: **04.11.82 JP 192478/82**

(43) Date of publication of application:
**26.11.86 Bulletin 86/48**

(45) Publication of the grant of the patent:
**13.03.91 Bulletin 91/11**

(84) Designated Contracting States:
**DE FR GB IT**

(56) References cited:
**DE-A- 2 441 385**

**PATENTS ABSTRACTS OF JAPAN, vol. 4, no. 48 (E-6)[530], 12th April 1980; & JP - A - 55 19 820**

**PATENTS ABSTRACTS OF JAPAN, vol. 1, no. 34, 31st March 1977, page 1703 E 76; & JP - A - 51 130 178**

**PATENTS ABSTRACTS OF JAPAN, vol. 2, no. 22, 14th February 197, page 11498 E 77; & JP - A - 52 141 590**

(73) Proprietor: **HITACHI, LTD.**
**6, Kanda Surugadai 4-chome**
**Chiyoda-ku, Tokyo 100(JP)**

(72) Inventor: **Sunami, Hideo**
**2196-421, Hirai Hinodemachi**
**Nishitama-gun Tokyo(JP)**
Inventor: **Kure, Tokuo**
**1-217-A6, Higashi-koigakubo**
**Kokubunji-shi Tokyo(JP)**
Inventor: **Kawamoto, Yoshifumi**
**3511-14, Kawashiri Shiroyama-cho**
**Tsukui-gun Kanagawa-ken(JP)**
Inventor: **Miyao, Masanobu**
**1188-5-107, Kamiarai**
**Tokorozawa-shi Saitama-ken(JP)**

(74) Representative: **Strehl, Schübel-Hopf, Groening**
**Maximilianstrasse 54 Postfach 22 14 55**
**W-8000 München 22(DE)**

## Description

Background of the Invention

The present invention relates to a semiconductor memory, and in particular to a one-transistor dynamic MOS memory which enables an increase in memory capacity without increasing the space required, and which is suitable for increasing memory size.

The memory size of MOS dynamic memories quadrupled in the approximately three years after the 1K bit dynamic random access memory (hereinafter referred to ad dRAM) was first sold in the early 1970s. 16-pin DIPs (dual inline packages) are mainly used for accommodatting memory chips, but this imposes a limitation on the size of the cavity for inserting the chips. Therefore the size of memory chip has increased by approximately 1.4 times, despite the fact that the degree of integration has quadrupled. (Since large quantities of dRAMs are used, it is necessary to curb any increase of the chip size , if only from the standpoint of cost.) Therefore, the area of memory cell per bit of one storage unit is greatly reduced, i.e., is reduced to above one-third, owing to the quadrupled degree of integration. The capacity C of a semiconductor memory is expressed by $C = \epsilon A/T_i$ (where $\epsilon$ is the permeability of the insulator, A the capacitor area, and $T_i$ the insulator thickness). Therefore, if the area A is reduced to one-third, the capacity C decreases to one-third so long as $\epsilon$ and $T_i$ remain the same. The signal quantity S of a memory capacitor changes in proportion to the charge quantity Qs stored, and the charge quantity Qs is a product of the capacity C and the memory voltage Vs. Therefore, the charge quantity Qs decreases with a decrease in the capacitor area A, and the signal quantity S decreases correspondingly.

If noise voltage is denoted by N, the signal-to-noise ratio (S/N ratio) decreases with a decrease in the signal quantity S, raising a problem with regard to the operation of the circuit. Usually, therefore, a decrease in the capacitor area A is compensated by decreasing the insulator thickness $T_i$. Therefore, as the degree of integration of dRAMs increases from 4K bit to 16K bit to 64K bit, the typical thickness $T_i$ of the $SiO_2$ film used as the insulator gradually decreases from 100 nm to 75 nm and then to 50 nm.

Recently it has been confirmed that noise results from electric charges of a maximum of approximately 200 fC generated in a silicon substrate by alpha particles radiated from radioactive heavy metals (such as U, Th, etc.) within the package. In order to maintain reliability in operation, therefore, it is not possible to reduce the signal quantity, i.e., the electric charge, to below about 200 fC.

Because of these reasons, therefore, attempts have been made to reduce the thickness of the insulator further, raising a problem with regard to the dielectric breakdown of the insulator. The $SiO_2$ film which is usually used as the insulator of the capacitor has a dielectric withstand electric field of a maximum of $10^7$ V/cm. Therefore, a 10 nm thick $SiO_2$ film will break down permanently, or be degraded, when a voltage of 10 volts is applied. Using such a device close to its maximum dielectric withstand electric field causes a serious problem with regard to its long-term reliability, if it does not break down permanently.

A one-transistor dRAM memory cell may consist of a capacitor for storing electric charge, and a switching MOS transistor. The drain of the switching MOS transistor is connected to a bit line, and its gate is connected to a word line.

Such a memory cell is operated by the reading out of the signal charge stored in the capacitor by the switching MOS transistor.

If the stray capacitance of a stray capacitor of the bit line is denoted by $C_D$ and the capacity of capacitor of the memory cell by $C_S$, one of the main figures of merit of the memory array is expressed by $C_S/C_D$. The S/N ratio of the memory array corresponds exactly to $C_S/C_D$. To improve the S/N ratio, furthermore, it is important to increase the capacity $C_S$ of the capacitor of the memory cell, and reduce the stray capacitance $C_D$ of the bit line

In the conventional memory cell, the area available for the region of the capacitor $C_S$ acting as the memory capacitor inevitably decreases with a decrease in the size of the memory cell. Unless the thickness of the gate insulating film is reduced, therefore, the capacity $C_S$ decreases, thereby causing a serious problem concerning memory operation.

To solve the above problem, a memory is disclosed in JP-A-51-130178, in which a narrow groove is formed in the silicon substrate, and a capacitor that acts as the memory capacitor is formed on the surfaces of the groove. In this memory, the side and bottom surfaces of the groove are utilized as the electrode surfaces of the capacitor, providing the advantage that the electrode area is considerably increased without increasing the space required, compared with the memory of the conventional construction.

JP-A-55-19820 further discloses a memory cell in which a capacitor and a switching transistor are formed laterally adjacent each other, the capacitor being composed of a surface portion of a silicon substrate and a silicon layer disposed on the substrate with an $SiO_2$ layer therebetween. Here again, part of the substrate is utilized for the capacitor.

WO 81/03241 discloses a semiconductor in-

tegrated circuit such as a RAM in which grooves are formed in a semiconductor body. The side walls of the groove are covered by an insulating film. The interior of the groove is filled by conductive material forming a first electrode of a capacitor, the other electrode is formed by a doped layer surrounding the groove, and having a conductivity type opposite to that of the substrate.

## Summary of the Invention

The object of the present invention is to provide a semiconductor memory which has a capacitor with good characteristics but requires only a small space, yet overcoming the serious problems such as the alpha-particle induced disturbances that arise with a decrease in size of a memory cell, while maintaining high S/N ratio and breakdown voltage.

These objects are achieved by the features of claim 1.

## Brief Description of the Drawing

The single Figure is a section view through an embodiment of the present invention.

## Detailed Description of the Invention

In the embodiment described below, a memory is provided which has a capacitor in a memory capacitor portion which has an increased capacity without requiring an increase space, and which is hardly affected at all by external noise, the capacitor being constructed within a groove formed in the substrate.

In the drawing, reference numeral 3 denotes a bit line, 4 a word line, 10 a p-type silicon substrate, 12 a first intermediate insulation film, 14 a second intermediate insulation film, 15 an n-type diffusion layer, 17 a groove, 18 a capacitor insulation film, 19 a capacitor electrode, 23 an SOI layer, and 24 a transistor channel.

For forming this embodiment, a groove 17 is etched in the substrate 10, thereafter the capacitor insulation film 18 is desposited in the groove and then a single crystalline silicon film is formed on said insulation film 18, thereby forming an SOI (silicon-on-insulator) construction which includes places that will become the capacitor electrode 19 and the diffusion layer 15 in subsequent steps. Namely, a polycrystalline or amorphous silicon film is deposited over the whole surface, or over part of the surface , and the whole or part of the surface is heated by a laser beam or by a heater, so that a monocrystalline layer 23 grows on the insulation film after the silicon film melts, or with the silicon film maintained in the solid phase. Although not shown, the monocrystallization takes place easily if a piece of silicon film of SOI construction is brought into contact with the silicon substrate 10.

Thereafter, a gate oxide film 12 and a gate 4 are deposited on the SOI layer 23, followed by the formation of an $n^+$-type layer, so that one side acts as the capacitor electrode 19 and the other side as the diffusion layer 15 connected to the bit line 3. No switching transistor 2 is formed in the silicon substrate 10; i.e., the substrate 10 may be of any conductivity type. That is, if the substrate 10 is n-type, the silicon substrate 10 itself acts as a plate.

A dynamic memory, in general, has peripheral circuits with various functions formed around the memory cell, and it is difficult to make the whole of the silicon substrate 10 n-type. In this case, however, a doped layer may be provided as a plate, and only the portion of the memory cell need be n-type.

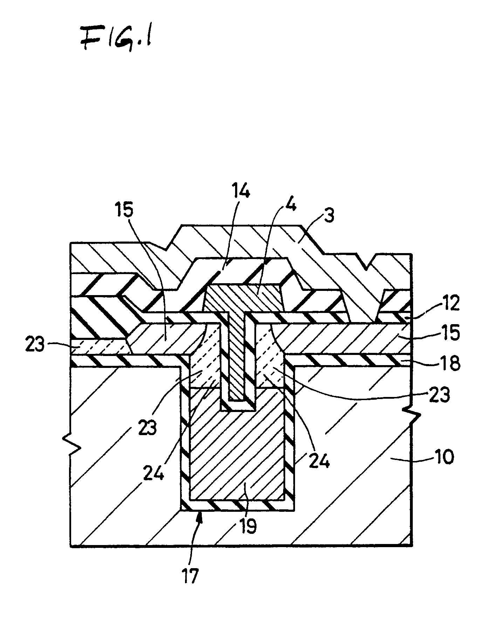

In this embodiment the groove has a simple rectangular shape, as shown in Fig. 1. Capacity increases with an increase in the surface area of the capacitor electrode 19. Therefore, the capacitor can be increased to more than that of a simple rectangular shape, while maintaining the same space. That is, the capacity can be increased by forming the groove in a comb shape or in two or more small grooves or in an annular groove. Therefore, individual steps can be replaced by others in a variety of ways. In all the embodiments, however, the common point remains that the side walls of the groove formed in the substrate are utilized as a capacitor part.

The word line 4 has the form of a continuous gate within a memory cell array. It is, however, also possible to form polycrystalline silicon transfer gates of switching transistors that are not continuous, but are separate between memory cells, and connect the gates by the word line 4 using new contact holes. This makes it possible to achieve a high switching speed by using polycrystalline silicon gates which have heretofore been evaluated for their reliability, and by utilizing the advantage of the low resistance of aluminum.

In the embodiment shown in the drawing, a transistor channel is 24 is formed in the vertical in the vertical direction within the SOI layer 23. The vertical junction transistor can be adapted to every kind of memory cell which employs SOI.

As described in the beginning, the invention deals with the use of an n-channel MOS transistor. To form a p-channel transistor, impurities of the opposite conductivity type should be used. Namely, the phosphorus or arsenic ions should be replaced with boron or aluminum ions, and the boron ions should be replaced by phosphorus, arsenic, or antimony ions.

In the semiconductor memory of the present invention, pairs of electrons and positive holes generated in large amounts by alpha particles within the silicon substrate seldom flow into the capacitor electrode 19 owing to its construction. With a semiconductor memory employing SOI, in parti cular, pairs of electrons and positive holes are not able to enter the capacitor electrode 19. Accordingly, the semiconductor memory according to the present invention is very stable against alpha particles.

## Claims

1. A semiconductor memory including an insulated gate-field effect transistor and a capacitor formed on a semiconductor substrate (10), said capacitor comprising a first electrode constituted by the sidewalls of a groove (17) formed in the substrate (10), an insulating film (l8) formed on the walls of said groove, and a second electrode (19) formed in said groove (17) on said insuinsulating film (18), said capacitor being coupled to the source or drain of said field-effect transistor,

    characterized in that said field effect transistor is formed over said capacitor and the channel (24) of said field-effect transistor is formed vertically.

2. The semiconductor memory of claim 1, wherein the channel (24) of said field-effect transistor is formed within a single-crystalline layer (23).

3. The semiconductor memory of claim 1 or 2, wherein the gate insulation film (12) of said field-effect transistor and the insulating film (18) of said capacitor are formed by different steps.

4. The semiconductor memory of any of claims 1 to 3, wherein the source or drain region (15) of said field-effect transistor is provided at both sides of its gate electrode (4) in a cross-sectional plane.

5. The semiconductor memory of any of claims 1 to 4, wherein the gate electrode (4) of said field-effect transistor is formed in a recess.

6. The semiconductor memory of claim 5, wherein the channel (24) of said field-effect transistor is provided at a side wall of said recess.

## Revendications

1. Mémoire à semiconducteurs comprenant un transistor à effet de champ à grille isolée et un condensateur formés sur un substrat semiconducteur (10), ledit condensateur comprenant une première électrode constituée par les parois latérales d'une gorge (17) formée dans le substrat (10), une pellicule isolante (18) formée sur les parois de ladite gorge, et une seconde électrode (19) formée dans ladite gorge (17) sur ladite pellicule isolante (18), ledit condensateur étant relié à la source ou au drain dudit transistor à effet de champ, caractérisée en ce que ledit transistor à effet de champ est formé au-dessus dudit condensateur et le canal (24) dudit transistor à effet de champ est formé verticalement.

2. Mémoire à semiconducteurs selon la revendication 1, dans laquelle le canal (24) dudit transistor à effet de champ est formé à l'intérieur d'une couche monocristalline (23).

3. Mémoire à semiconducteurs selon la revendication 1 ou 2, dans laquelle la pellicule d'isolement de grille (12) dudit transistor à effet de champ et la pellicule isolante (18) dudit condensateur sont formées par des étapes différentes.

4. Mémoire à semiconducteurs selon l'une quelconque des revendications 1 à 3, dans laquelle la région de source ou de drain (15) dudit transistor à effet de champ est prévue sur les deux côtés de son électrode de grille (4) dans un plan de coupe transversal.

5. Mémoire à semiconducteurs selon l'une quelconque des revendications 1 à 4, dans laquelle l'électrode de grille le (4) dudit transistor à effet de champ est formée dans un évidement.

6. Mémoire à semiconducteurs selon la revendication 5, dans laquelle le canal (24) dudit transistor à effet de champ est prévu sur une paroi latérale dudit évidement.

## Ansprüche

1. Halbleiterspeicher mit einem Isolierschicht-Feldeffekttransistor und einem Kondensator, ausgebildet auf einem Halbleitersubstrat (10), wobei der Kondensator eine erste Elektrode, die von den Seitenwänden einer in dem Substrat (10) geformten Nut (17) gebildet ist, eine an den Nutwänden ausgebildete Isolierschicht (18) und eine in der Nut (17) auf der Isolierschicht (18) ausgebildete zweite Elektrode (19) umfaßt und mit Source oder Drain des Feldeffekttransistors gekoppelt ist,

dadurch gekennzeichnet, daß der Feldeffekttransistor über dem Kondensator ausgebildet ist und der Kanal (24) des Feldeffekttransistors vertikal verläuft.

2. Halbleiterspeicher nach Anspruch 1, wobei der Kanal (24) des Feldeffekttransistors innerhalb einer einkristallinen Schicht (23) ausgebildet ist.

3. Halbleiterspeicher nach Anspruch 1 oder 2, wobei die Gate-Isolierschicht (12) des Feldeffekttransistors und die Isolierschicht (18) des Kondensators in unterschiedlichen Schritten ausgebildet sind.

4. Halbleiterspeicher nach einem der Ansprüche 1 bis 3, wobei die Source- oder die Drain-Zone (15) des Feldeffekttransistors in einer Querschnittsebene zu beiden Seiten von dessen Gate-Elektrode (4) vorgesehen ist.

5. Halbleiterspeicher nach einem der Ansprüche 1 bis 4, wobei die Gate-Elektrode (4) des Feldeffekttransistors in einer Vertiefung ausgebildet ist.

6. Halbleiterspeicher nach Anspruch 5, wobei der Kanal (24) des Feldeffekttransistors an einer Seitenwand der Vertiefung vorgesehen ist.

FIG.1